# EUROPEAN PATENT APPLICATION

(11) **EP 4 132 007 A1**
(43) Date of publication of application: **08.02.2023**
(21) Application number: 21780778.3
(22) Date of filing: 25.02.2021
(51) Int. Cl.: H04R 17/00, H01L 41/083, H01L 41/09, H01L 41/18, H01L 41/257

(54) **MULTILAYER PIEZOELECTRIC ELEMENT**

(30) Priority: 30.03.2020 JP 2020059969
(71) Applicant: FUJIFILM Corporation, Tokyo 106-8620 (JP)
(72) Inventor: KAGAWA Yusuke, Minamiashigara-shi, Kanagawa 250-0193 (JP); ASHIKAWA Teruo, Minamiashigara-shi, Kanagawa 250-0193 (JP); HIRAGUCHI Kazuo, Minamiashigara-shi, Kanagawa 250-0193 (JP)
(74) Representative: Klunker IP Patentanwälte PartG mbB
(86) International application number: PCT/JP2021/007032
(87) International publication number: WO 2021/199800

(57) **Abstract**

Provided is a laminated piezoelectric element capable of suppressing a short circuit between piezoelectric films in a laminated piezoelectric element in which a plurality of layers of a piezoelectric film formed by interposing a piezoelectric layer between an electrode layer and a protective layer are laminated. The laminated piezoelectric element is formed by laminating a plurality of layers of piezoelectric films each having a piezoelectric layer, two electrode layers between which the piezoelectric layer is interposed, and two protective layers respectively covering the electrode layers. At least a part of each end side of the adjacent piezoelectric films is located at a different position in a plane direction.

## Description

### BACKGROUND OF THE INVENTION

### 1. Field of the Invention

The present invention relates to a laminated piezoelectric element.

### 2. Description of the Related Art

Piezoelectric elements are used in various applications as so-called exciters (exciton) that vibrate articles to generate sound in a case where the elements are attached in contact with various articles. For example, by attaching an exciter to an image display panel, a screen, or the like and vibrating them, sound can be generated instead of a speaker.

By the way, in a case where an exciter is attached to a flexible image display device, a rollable screen, or the like, it is necessary for the exciter itself to be flexible (rollable) at least in a case where the exciter is not in use.

As a flexible piezoelectric element, a piezoelectric film in which a piezoelectric layer is interposed between an electrode layer and a protective layer has been proposed.

For example, JP2014-209724A describes an electroacoustic conversion film having a piezoelectric laminate, a metal foil for extracting an upper electrode, and a metal foil for extracting a lower electrode. The piezoelectric laminate has a polymer-based piezoelectric composite material that is formed by dispersing piezoelectric particles in a viscoelastic matrix consisting of a polymer material having viscoelasticity at room temperature, an upper thin film electrode that is formed on one surface of the polymer-based piezoelectric composite material and has an area of equal to or less than that of the polymer-based piezoelectric composite material, an upper protective layer that is formed on a surface of the upper thin film electrode and has an area of equal to or greater than that of the upper thin film electrode, a lower thin film electrode that is formed on the opposite surface of the upper thin film electrode of the polymer-based piezoelectric composite material and has an area equal to or less than that of the polymer-based piezoelectric composite material, and a lower protective layer that is formed on the surface of the lower thin film electrode and has an area equal to or larger than that of the lower thin film electrode. The metal foil for extracting the upper electrode is laminated on a part of the upper thin film electrode, and at least a part thereof is located outside the plane direction of the polymer-based piezoelectric composite material. The metal foil for extracting a lower electrode is laminated on a part of the lower thin film electrode, and at least a part thereof is located outside the plane direction of the polymer-based piezoelectric composite material.

Such a piezoelectric film is in the form of a film and has a limited spring constant. Therefore, an output thereof is insufficient in a case where the piezoelectric film is used as an exciter. Therefore, it is conceivable that the spring constant is increased by laminating the piezoelectric film and the output is increased.

### SUMMARY OF THE INVENTION

The piezoelectric film in which the piezoelectric layer is interposed between the electrode layer and the protective layer is formed into a long shape by, for example, roll-to-roll, and then cut into a desired size. In a case where the film is cut, burrs of the metal constituting the electrode layer may occur. Therefore, in a case where such piezoelectric films are laminated, it has been found that there is a problem that the electrode layers of adjacent piezoelectric films are short-circuited due to burrs since the distance between the layers is short.

In order to solve such a problem of the prior art, an object of the present invention is to provide a laminated piezoelectric element capable of suppressing a short circuit between piezoelectric films in a laminated piezoelectric element in which a plurality of layers of a piezoelectric film formed by interposing a piezoelectric layer between an electrode layer and a protective layer are laminated.

In order to solve such a problem, the present invention has the following configurations.
[1] A laminated piezoelectric element formed by laminating a plurality of layers of piezoelectric films each having a piezoelectric layer, two electrode layers between which the piezoelectric layer is interposed, and two protective layers respectively covering the electrode layers,
   in which at least a part of each end side of the adjacent piezoelectric films is located at a different position in a plane direction.
[2] The laminated piezoelectric element according to [1], in which each of the piezoelectric films has an end surface covering layer that covers an end surface of the piezoelectric film.
[3] The laminated piezoelectric element according to [1] or [2], in which a distance between the end sides of the adjacent piezoelectric films is equal to or greater than 0.05 mm and equal to or less than 2 mm.
[4] The laminated piezoelectric element according to any one of [1] to [3], in which the piezoelectric layer is polarized in a thickness direction, and
   the plurality of piezoelectric films are laminated such that polarization directions thereof are alternated.
[5] A laminated piezoelectric element in which a plurality of layers of a piezoelectric film having a piezoelectric layer, two electrode layers between which the piezoelectric layer is interposed, and two protective layers respectively covering the electrode layers are laminated by folding back the piezoelectric film one or more times,
   in which respective end sides of adjacent layers are located at different positions in a plane direction.
[6] The laminated piezoelectric element according to [5], in which the piezoelectric film has an end surface covering layer covering both end surfaces in a width direction orthogonal to a folding-back direction of the piezoelectric film.
[7] The laminated piezoelectric element according to [5] or [6], in which a shortest distance between the end sides of the adjacent layers is equal to or greater than 0.05 mm and equal to or less than 5 mm.

According to the present invention as described above, it is possible to provide a laminated piezoelectric element capable of suppressing a short circuit between piezoelectric films in a laminated piezoelectric element in which a plurality of layers of a piezoelectric film formed by interposing a piezoelectric layer between an electrode layer and a protective layer are laminated.

### BRIEF DESCRIPTION OF THE DRAWINGS

Fig. 1 is a diagram conceptually showing an example of a laminated piezoelectric element of the present invention.
Fig. 2 is a diagram conceptually showing an example of a piezoelectric film that constitutes the laminated piezoelectric element shown in Fig. 1.
Fig. 3 is a diagram conceptually showing another example of the laminated piezoelectric element of the present invention.
Fig. 4 is a diagram conceptually showing another example of the laminated piezoelectric element of the present invention.
Fig. 5 is a diagram conceptually showing another example of a piezoelectric film that constitutes the laminated piezoelectric element of the present invention.
Fig. 6 is a diagram conceptually showing another example of the laminated piezoelectric element of the present invention.
Fig. 7 is a diagram conceptually showing another example of the laminated piezoelectric element of the present invention.
Fig. 8 is a diagram conceptually showing another example of the laminated piezoelectric element of the present invention.
Fig. 9 is an enlarged view of a part of the laminated piezoelectric element.
Fig. 10 is an enlarged view of a part of a laminated piezoelectric element.
Fig. 11 is a diagram conceptually showing another example of the laminated piezoelectric element of the present invention.
Fig. 12 is a conceptual diagram for describing an example of a production method of the piezoelectric film.
Fig. 13 is a conceptual diagram for describing an example of the production method of the piezoelectric film.
Fig. 14 is a conceptual diagram for describing an example of the production method of the piezoelectric film.
Fig. 15 is a diagram conceptually showing another example of the laminated piezoelectric element of the present invention.
Fig. 16 is an exploded view of Fig. 15.
Fig. 17 is a diagram showing the piezoelectric film included in the laminated piezoelectric element of Fig. 15.
Fig. 18 is a diagram conceptually showing another example of the laminated piezoelectric element of the present invention.
Fig. 19 is a cross-sectional view taken along a line BB of Fig. 18.
Fig. 20 is a diagram conceptually showing a state in which the laminated piezoelectric element of Fig. 18 is opened.

### DESCRIPTION OF THE PREFERRED EMBODIMENTS

Hereinafter, a laminated piezoelectric element of the present invention will be described in detail on the basis of the preferred embodiments shown in the accompanying drawings.

Descriptions of the configuration requirements described below may be made on the basis of representative embodiments of the present invention, but the present invention is not limited to such embodiments.

In the present specification, a numerical range expressed using "to" means a range including numerical values described before and after "to" as a lower limit and an upper limit.

According to a first embodiment of the present invention,
a laminated piezoelectric element is formed by laminating a plurality of layers of piezoelectric films each having a piezoelectric layer, two electrode layers between which the piezoelectric layer is interposed, and two protective layers respectively covering the electrode layers.

Each end side of the adjacent piezoelectric films is located at a different position in a plane direction.

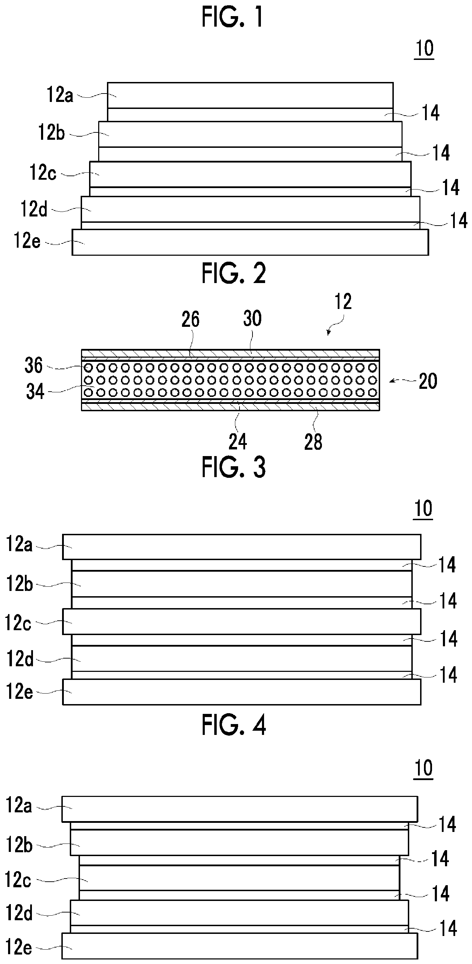

Fig. 1 conceptually shows an example of the laminated piezoelectric element of the present invention.

The laminated piezoelectric element 10 shown in Fig. 1 has a configuration in which five piezoelectric films are laminated, and adjacent piezoelectric films are cemented by an adhesive layer (cementing layer) 14. A power source for applying a driving voltage for stretching and contracting the piezoelectric film is connected to each piezoelectric film (not shown).

The laminated piezoelectric element 10 shown in Fig. 1 is formed by laminating five piezoelectric films, but the present invention is not limited thereto. That is, the number of laminated piezoelectric films may be two to four layers or six or greater layers as long as the laminated piezoelectric element of the present invention is formed by laminating a plurality of layers of the piezoelectric films. In this regard, the same applies to a laminated piezoelectric element, which will be described later.

Fig. 2 conceptually shows a piezoelectric film 12 in a cross-sectional view. In addition, in Fig. 1, piezoelectric films 12a to 12e have the same configuration except that the lamination orders and the widths are different. Therefore, in the following description, in a case where it is not necessary to distinguish the piezoelectric films, the piezoelectric films may be collectively referred to as the piezoelectric film 12.

As shown in Fig. 2, the piezoelectric film 12 has a piezoelectric layer 20 which is a sheet-like member having piezoelectric characteristics, a first electrode layer 24 laminated on one surface of the piezoelectric layer 20, a first protective layer 28 laminated on the first electrode layer 24, a second electrode layer 26 laminated on the other surface of the piezoelectric layer 20, and a second protective layer 30 laminated on the second electrode layer 26. That is, the piezoelectric film 12 has a protective layer that interposes the piezoelectric layer 20 between two electrode layers and covers each electrode layer. The piezoelectric film 12 will be described in detail later.

Here, in the laminated piezoelectric element of the present invention, the end sides of the adjacent piezoelectric films are at different positions in a plane direction. The plane direction is a plane direction of a principal surface of the piezoelectric film. The principal surface is a largest surface of a sheet-like member (layer, film, plate-like member).

Specifically, the piezoelectric film 12a laminated on the uppermost side in Fig. 1 and the piezoelectric film 12b laminated adjacent to the underlayer of the piezoelectric film 12a have different widths in the left-right direction in the drawing. Therefore, the positions of the end sides of the piezoelectric film 12 in the plane direction, that is, in a left-right direction in the drawing are different. More specifically, the width of the piezoelectric film 12b is greater than that of the piezoelectric film 12a, the left end side of the piezoelectric film 12b in the drawing is located closer to the left side than the left end side of the piezoelectric film 12a, and the right end side of the piezoelectric film 12b in the drawing is located closer to the right side than the right end side of the piezoelectric film 12a.

Further, the piezoelectric film 12b and the piezoelectric film 12c laminated adjacent to the underlayer of the piezoelectric film 12b have different widths in the left-right direction in the drawing. Therefore, the positions of the end sides of the piezoelectric film 12 in the plane direction, that is, in a left-right direction in the drawing are different. More specifically, the width of the piezoelectric film 12c is greater than that of the piezoelectric film 12b, the left end side of the piezoelectric film 12c in the drawing is located closer to the left side than the left end side of the piezoelectric film 12b, and the right end side of the piezoelectric film 12c in the drawing is located closer to the right side than the right end side of the piezoelectric film 12b.

Similarly, in the relationship between the piezoelectric film 12c and the piezoelectric film 12d laminated adjacent to the underlayer of the piezoelectric film 12c and the relationship between the piezoelectric film 12d and the piezoelectric film 12e laminated adjacent to the underlayer of the piezoelectric film 12d, the widths in the left-right direction in the drawing are different, and the plane directions of the piezoelectric film 12, that is, the positions of the end side in the left-right direction in the drawing are different. More specifically, the width of the piezoelectric film 12 in the underlayer is greater than the width of the piezoelectric film 12 adjacent to the upper layer thereof, and both the left and right end sides of the piezoelectric film 12 in the underlayer are located outside the end sides of the piezoelectric film 12 adjacent to the upper layer thereof.

As described above, the piezoelectric film in which the piezoelectric layer is interposed between the electrode layer and the protective layer is formed into a long shape by, for example, roll-to-roll, and then cut into a desired size. In a case where the film is cut, burrs of the metal constituting the electrode layer may occur. For this reason, in a case where the piezoelectric films cut to the same size are laminated, the distance between the layers is short. Therefore, it was found that there is a problem that the electrode layers of the adjacent piezoelectric films are short-circuited due to burrs.

On the other hand, in the laminated piezoelectric element 10 of the present invention, the plurality of piezoelectric films 12 each have a configuration in which the end sides of the adjacent piezoelectric films 12 are laminated so as to be at different positions in the plane direction. Thereby, a distance between the electrode layers of the adjacent piezoelectric films can be lengthened, and short-circuiting of the electrode layers can be suppressed.

Here, in the example shown in Fig. 1, a size of the piezoelectric film is larger at a position closer to the underlayer than the upper layer. However, in a case where the end sides of the adjacent piezoelectric films are at different positions in the plane direction, the present invention is not limited to this.

Fig. 3 is a diagram conceptually showing another example of the laminated piezoelectric element of the present invention.

The laminated piezoelectric element 10 shown in Fig. 3 has a configuration in which five piezoelectric films are laminated, and adjacent piezoelectric films are cemented by an adhesive layer (cementing layer) 14.

The piezoelectric film 12a laminated on the uppermost side in Fig. 3 and the piezoelectric film 12b laminated adjacent to the underlayer of the piezoelectric film 12a have different widths in the left-right direction in the drawing. Therefore, the positions of the end sides of the piezoelectric film 12 in the plane direction, that is, in a left-right direction in the drawing are different. More specifically, the width of the piezoelectric film 12a is greater than that of the piezoelectric film 12b, the left end side of the piezoelectric film 12a in the drawing is located closer to the left side (outside) than the left end side of the piezoelectric film 12b, and the right end side of the piezoelectric film 12a in the drawing is located closer to the right side (outside) than the right end side of the piezoelectric film 12b.

Further, the piezoelectric film 12b and the piezoelectric film 12c laminated adjacent to the underlayer of the piezoelectric film 12b have different widths in the left-right direction in the drawing. Therefore, the positions of the end sides of the piezoelectric film 12 in the plane direction, that is, in a left-right direction in the drawing are different. More specifically, the width of the piezoelectric film 12c is greater than that of the piezoelectric film 12b, the left end side of the piezoelectric film 12c in the drawing is located closer to the left side (outside) than the left end side of the piezoelectric film 12b, and the right end side of the piezoelectric film 12c in the drawing is located closer to the right side (outside) than the right end side of the piezoelectric film 12b.

Further, the width of the piezoelectric film 12d laminated on the underlayer of the piezoelectric film 12c is less than that of the piezoelectric film 12c, the left end side of the piezoelectric film 12c in the drawing is located closer to the left side (outside) than the left end side of the piezoelectric film 12d, and the right end side of the piezoelectric film 12c in the drawing is located closer to the right side (outside) than the right end side of the piezoelectric film 12d.

Further, the width of the piezoelectric film 12e laminated on the underlayer of the piezoelectric film 12d is greater than that of the piezoelectric film 12d, the left end side of the piezoelectric film 12e in the drawing is located closer to the left side (outside) than the left end side of the piezoelectric film 12d, and the right end side of the piezoelectric film 12e in the drawing is located closer to the right side (outside) than the right end side of the piezoelectric film 12d.

That is, in the example shown in Fig. 3, the large-width piezoelectric film 12 and the small-width piezoelectric film 12 are alternately laminated, and positions of both the left and right end sides of the large-width piezoelectric film 12 and the small-width piezoelectric film 12 are different.

Fig. 4 is a diagram conceptually showing another example of the laminated piezoelectric element of the present invention.

The laminated piezoelectric element 10 shown in Fig. 4 has a configuration in which five piezoelectric films are laminated, and adjacent piezoelectric films are cemented by an adhesive layer (cementing layer) 14.

The piezoelectric film 12a laminated on the uppermost side in Fig. 3 and the piezoelectric film 12b laminated adjacent to the underlayer of the piezoelectric film 12a have different widths in the left-right direction in the drawing. Therefore, the positions of the end sides of the piezoelectric film 12 in the plane direction, that is, in a left-right direction in the drawing are different. More specifically, the width of the piezoelectric film 12a is greater than that of the piezoelectric film 12b, the left end side of the piezoelectric film 12a in the drawing is located closer to the left side (outside) than the left end side of the piezoelectric film 12b, and the right end side of the piezoelectric film 12a in the drawing is located closer to the right side (outside) than the right end side of the piezoelectric film 12b.

Further, the piezoelectric film 12b and the piezoelectric film 12c laminated adjacent to the underlayer of the piezoelectric film 12b have different widths in the left-right direction in the drawing. Therefore, the positions of the end sides of the piezoelectric film 12 in the plane direction, that is, in a left-right direction in the drawing are different. More specifically, the width of the piezoelectric film 12b is greater than that of the piezoelectric film 12c, the left end side of the piezoelectric film 12b in the drawing is located closer to the left side (outside) than the left end side of the piezoelectric film 12c, and the right end side of the piezoelectric film 12b in the drawing is located closer to the right side (outside) than the right end side of the piezoelectric film 12c.

Further, the width of the piezoelectric film 12d laminated on the underlayer of the piezoelectric film 12c is greater than that of the piezoelectric film 12c, the left end side of the piezoelectric film 12d in the drawing is located closer to the left side (outside) than the left end side of the piezoelectric film 12c, and the right end side of the piezoelectric film 12d in the drawing is located closer to the right side (outside) than the right end side of the piezoelectric film 12c.

Further, the width of the piezoelectric film 12e laminated on the underlayer of the piezoelectric film 12d is greater than that of the piezoelectric film 12d, the left end side of the piezoelectric film 12e in the drawing is located closer to the left side (outside) than the left end side of the piezoelectric film 12d, and the right end side of the piezoelectric film 12e in the drawing is located closer to the right side (outside) than the right end side of the piezoelectric film 12d.

That is, in the example shown in Fig. 4, the size of the piezoelectric film is larger at a position closer to the outside (surface side) than the center in the lamination direction.

Here, each piezoelectric film 12 may have an end surface covering layer that covers an end surface of the piezoelectric film 12.

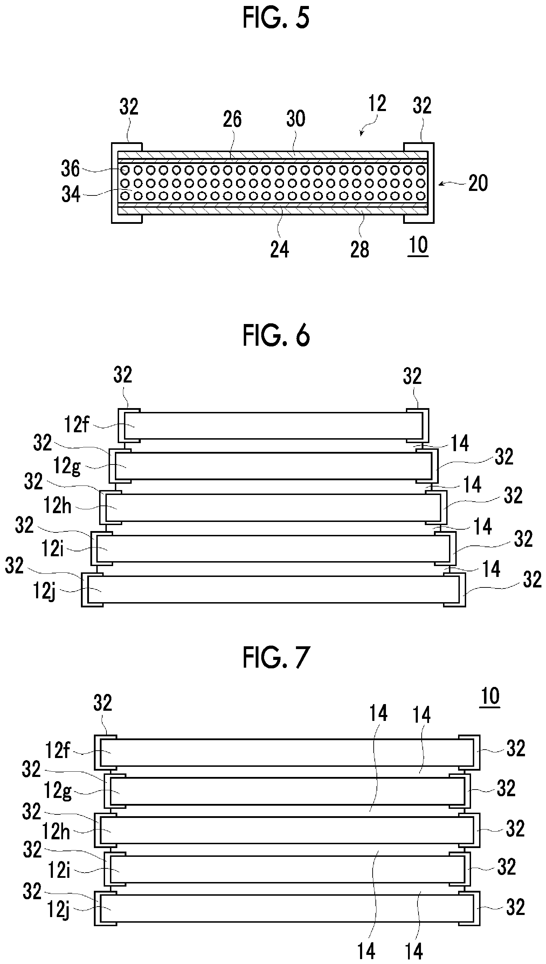

Fig. 5 conceptually shows the piezoelectric film 12 in a cross-sectional view.

As shown in Fig. 5, the piezoelectric film 12 has a piezoelectric layer 20 which is a sheet-like member having piezoelectricity, a first electrode layer 24 laminated on one surface of the piezoelectric layer 20, a first protective layer 28 laminated on the first electrode layer 24, a second electrode layer 26 laminated on the other surface of the piezoelectric layer 20, a second protective layer 30 laminated on the second electrode layer 26, and an end surface covering layer 32 that covers the end surfaces of the laminate which is laminated in an order of the first protective layer 28, the first electrode layer 24, the piezoelectric layer 20, the second electrode layer 26, and the second protective layer 30. The end surface covering layer 32 has an insulation property.

In the example shown in Fig. 5, the end surface covering layer 32 covers a region from a part of the surface of the first protective layer 28 to the end surface of the laminate and a part of the surface of the second protective layer 30.

The end surface covering layer 32 will be described in detail later.

By having the insulating end surface covering layer 32, it is possible to more suitably suppress short-circuiting between the electrode layers of the adjacent piezoelectric films 12.

Figs. 6 to 8 show examples in which the piezoelectric films 12 having the end surface covering layers 32 are laminated such that the end sides of the adjacent piezoelectric films 12 are at different positions in the plane direction.

The example shown in Fig. 6 is an example in which the piezoelectric films 12 are laminated in the same manner as the example shown in Fig. 1 except that the piezoelectric film 12 has an end surface covering layer.

The example shown in Fig. 7 is an example in which the piezoelectric film 12 is laminated in the same manner as the example shown in Fig. 3, except that the piezoelectric film 12 has an end surface covering layer.

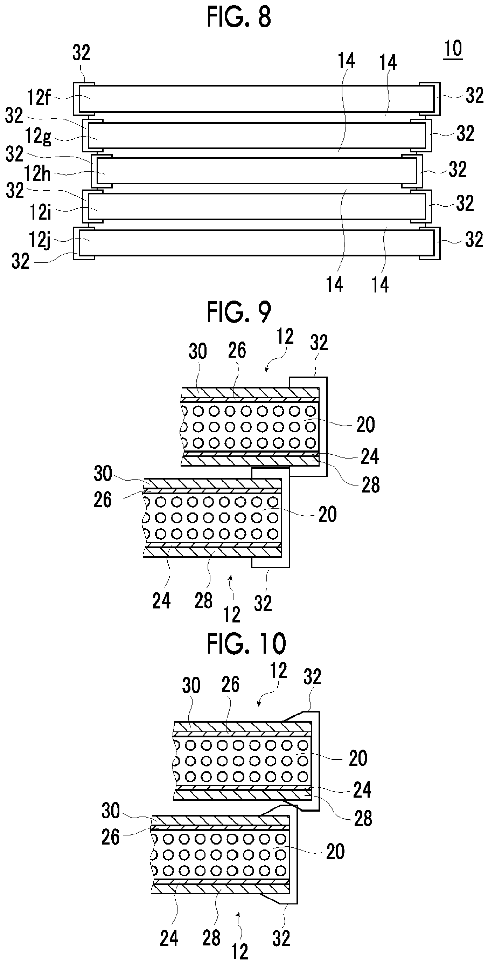

The example shown in Fig. 8 is an example in which the piezoelectric film 12 is laminated in the same manner as the example shown in Fig. 4, except that the piezoelectric film 12 has an end surface covering layer.

Here, in a case where the piezoelectric film 12 has the end surface covering layer 32, as shown in Fig. 5, the end surface covering layer 32 is also formed on the surface of the protective layer at the end part. Therefore, the thicknesses of the piezoelectric film 12 at both end parts are greater than that of the central part due to the end surface covering layer 32. As a result, distribution of the thicknesses occurs. In a case where the piezoelectric films having such an end surface covering layer are laminated with the same size, parts where thicknesses of both end parts are large (parts where the end surface covering layer is formed) are laminated, and a difference between the thicknesses of both end parts and the thickness of the central part is larger in terms of the laminated piezoelectric element.

In a case where there is such a difference in thickness, a difference in rigidity occurs. Therefore, for example, in a case where the laminated piezoelectric material is attached as an exciter to a screen that is rollable, a part having high rigidity is difficult to bend during rolling. Therefore, a dent can be formed on the screen.

On the other hand, in the laminated piezoelectric element of the present invention, the end sides of the adjacent piezoelectric films are at different positions in a plane direction. Therefore, as shown in Figs. 6 to 8, the parts of the adjacent piezoelectric films 12 on which the end surface covering layer 32 is formed do not overlap in the plane direction. Therefore, in terms of the laminated piezoelectric element, the difference between the thicknesses of both end parts and the thickness of the central part can be reduced, and occurrence of the difference in rigidity can be suppressed. Thereby, in a case where the laminated piezoelectric material is attached to a rollable screen or the like as an exciter, it is possible to suppress formation of imprints on the screen during rolling.

From the viewpoint of preventing short-circuiting and reducing the difference in thickness between the end parts and the central part in a case where the end surface covering layer is formed, the distance between the end sides of the adjacent piezoelectric films 12 in the plane direction is preferably equal to or greater than 0.05 mm and equal to or less than 5 mm, more preferably equal to or greater than 0.2 mm and equal to or less than 3 mm, and even more preferably equal to or greater than 0.3 mm and equal to or less than 2 mm.

The distance between the end sides of the adjacent piezoelectric films 12 in the plane direction is a distance in the direction orthogonal to the extending direction of the short side. That is, the distance is a distance in the vertical direction of the end surface.

Further, the end sides of the adjacent piezoelectric films may be at different positions in the plane direction at least a part of the end sides of the piezoelectric film. However, from the viewpoint of preventing short circuit, in the entire region of the end sides of the piezoelectric film, it is preferable that the end sides of the adjacent piezoelectric films are located at positions different in the plane direction.

Further, in at least one group of adjacent piezoelectric films, the end sides may be at different positions in the plane direction, and it is preferable that the end sides are at different positions in the plane direction in all the groups of adjacent piezoelectric films. That is, there may be a group in which the end sides of adjacent piezoelectric films are at the same position in the plane direction.

Here, as in the example shown in Figs. 6 to 8, in the case where each piezoelectric film 12 has the end surface covering layer 32, as shown in Fig. 9, it is preferable to set the distance in the plane direction between the end sides of the adjacent piezoelectric films 12 such that the end surface covering layers 32 of the adjacent piezoelectric films 12 do not overlap as viewed from the plane direction. As will be described later, the end surface covering layer 32 may be a coating layer formed by coating or the like, or may be a layer formed by cementing an insulating tape, and so on. In any case, the maximum length of a part of the end surface covering layer 32 that rides on the principal surface in the plane direction is about 5 mm. Therefore, from the viewpoint of preventing the end surface covering layers 32 of the adjacent piezoelectric films 12 from overlapping with each other, the distance between the end sides of the adjacent piezoelectric films 12 in the plane direction is preferably about 5 mm at the maximum.

Further, the end surface covering layers 32 of the adjacent piezoelectric films 12 may overlap with each other. In particular, in a case where the end surface covering layer 32 is a coating layer, as shown in Fig. 10, the thickness of the part of the end surface covering layer 32 riding on the principal surface gradually decreases as the distance from the end surface of the piezoelectric film 12 increases. In such a manner, a part where the thickness of the end surface covering layer 32 is gradually reduced may overlap with the end surface covering layer 32 of the adjacent piezoelectric film 12.

Here, in the examples shown in Figs. 6 to 8, a configuration in which the plurality of piezoelectric films 12 having the end surface covering layers 32 are laminated, that is, a configuration in which the end surface covering layer 32 is laminated on each piezoelectric film 12 is adopted. However, the present invention is not limited to this.

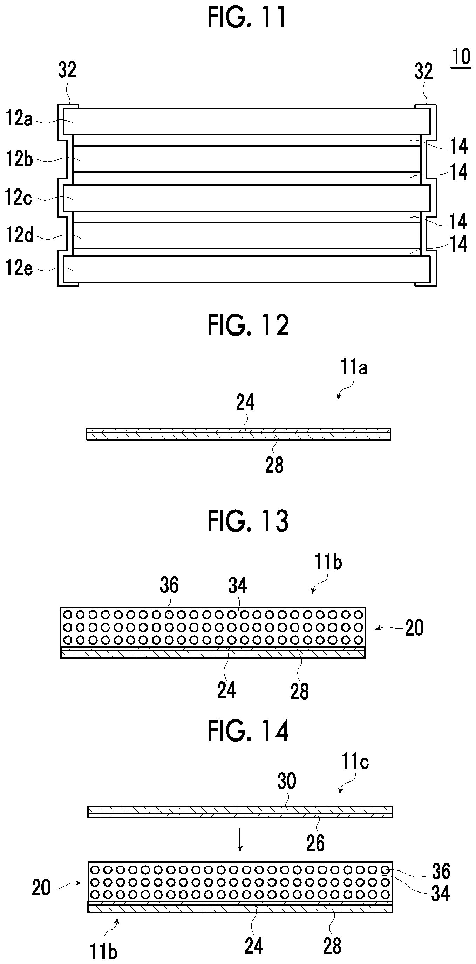

As in the example shown in Fig. 11, the configuration may include an end surface covering layer 32 that covers the end surface of the laminate in which the plurality of piezoelectric films 12 are laminated. That is, after laminating the plurality of piezoelectric films 12 on which the end surface covering layer 32 is not formed, an end surface covering layer covering the end surface of the laminate may be formed.

The shape of each piezoelectric film is not particularly limited and may be various shapes such as a circular shape, an elliptical shape, a rectangular shape, a polygonal shape, and an indefinite shape. The plurality of laminated piezoelectric films may have similar shapes in which the adjacent piezoelectric films have different sizes in the plane direction.

For example, the laminated piezoelectric element 10 of the present invention is used as an exciter for being cemented to a vibration plate by an adhesive layer and generating sound from the vibration plate.

As will be described later, in the laminated piezoelectric element 10 of the present invention, it is preferable that the piezoelectric layer 20 constituting the piezoelectric films 12 which are laminated in a plurality of layers is formed by dispersing piezoelectric particles 36 in the viscoelastic matrix 34. Further, the first electrode layer 24 and the second electrode layer 26 are provided with the piezoelectric layer 20 interposed therebetween in the thickness direction.

In a case where a voltage is applied to the first electrode layer 24 and the second electrode layer 26 of the piezoelectric film having the piezoelectric layer 20, the piezoelectric particles 36 stretch and contract in the polarization direction according to the applied voltage. As a result, the piezoelectric film (piezoelectric layer 20) contracts in the thickness direction. At the same time, the piezoelectric film stretches and contracts in the plane direction due to the Poisson's ratio.

The degree of stretching and contracting is equal to or greater than about 0.01% and equal to or less than about 0.1%.

The thickness of the piezoelectric layer 20 is preferably equal to or greater than about 10 µm and equal to or less than about 300 µm. Accordingly, the degree of stretching and contracting in the thickness direction is as extremely small as about 0.3 µm at the maximum.

Contrary to this, the piezoelectric film, that is, the piezoelectric layer 20, has a size much larger than the thickness in the plane direction. Accordingly, for example, in a case where the length of the piezoelectric film is 20 cm, the piezoelectric film stretches and contracts by a maximum of about 0.2 mm as a voltage is applied.

As described above, the laminated piezoelectric element 10 is cemented to the vibration plate by an adhesive layer. Accordingly, the stretching and contracting of the piezoelectric film causes the vibration plate to bend, and as a result, the vibration plate vibrates in the thickness direction.

The vibration plate emits a sound due to the vibration in the thickness direction. That is, the vibration plate vibrates in accordance with the magnitude of the voltage (driving voltage) applied to the piezoelectric film, and generates a sound in accordance with the driving voltage applied to the piezoelectric film.

Here, it is known that in a case where a general piezoelectric film consisting of a polymer material such as PVDF is stretched in a uniaxial direction after being subjected to polarization processing, the molecular chains are oriented with respect to the stretching direction, and as a result, high piezoelectric characteristics are obtained in the stretching direction. Therefore, a general piezoelectric film has in-plane anisotropy in the piezoelectric characteristics, and has anisotropy in the amount of stretching and contracting in the plane direction in a case where a voltage is applied.

On the other hand, a piezoelectric film having a polymer-based piezoelectric composite material in which piezoelectric particles are dispersed in a viscoelastic matrix is able to obtain large piezoelectric characteristics without stretching processing after polarization processing. Therefore, the piezoelectric film has no in-plane anisotropy in the piezoelectric characteristics, and stretches and contracts isotropically in all directions in the plane direction. That is, the piezoelectric film stretches and contracts isotropically and two-dimensionally. In the laminated piezoelectric element 10 in which such piezoelectric films that stretch and contract isotropically and two-dimensionally are laminated, compared to a case where general piezoelectric films made of PVDF or the like that stretch and contract greatly in only one direction are laminated, the vibration plate can be vibrated with a large force, and a louder and more beautiful sound can be generated.

As described above, the laminated piezoelectric element of the present invention is a laminate of a plurality of such piezoelectric films.

Therefore, even though the rigidity of each piezoelectric film is low and the stretching and contracting force thereof is small, the rigidity is increased by laminating the piezoelectric films, and the stretching and contracting force as the laminated piezoelectric element 10 is increased. As a result, in the laminated piezoelectric element 10 of the present invention, even in a case where the vibration plate has a certain degree of rigidity, the vibration plate is sufficiently bent with a large force and the vibration plate can be sufficiently vibrated in the thickness direction, whereby the vibration plate can generate a sound.

In addition, the thicker the piezoelectric layer 20, the larger the stretching and contracting force of the piezoelectric film, but the larger the driving voltage required for stretching and contracting by the same amount. Here, as described above, in the laminated piezoelectric element 10 of the present invention, a preferable thickness of the piezoelectric layer 20 is about 300 µm at the maximum. Therefore, even in a case where the voltage applied to each piezoelectric film is small, it is possible to sufficiently stretch and contract the piezoelectric films.

As described above, in the piezoelectric film, the absolute amount of stretching and contracting of the piezoelectric layer 20 in the thickness direction is extremely small, and the stretching and contracting of the piezoelectric film is substantially only in the plane direction.

Accordingly, even in a case where the polarization directions of the laminated piezoelectric films are opposite to each other, all the piezoelectric films stretch and contract in the same direction as long as the polarities of the voltages applied to the first electrode layer 24 and the second electrode layer 26 are correct.

The vibration plate to which the laminated piezoelectric element is cemented is not limited, and various articles can be used.

As the vibration plate, for example, plate materials such as resin plates and glass plates, advertisement or notification media such as signboards, office devices and furniture such as tables, whiteboards, and projection screens, display devices such as organic electroluminescence (organic light emitting diode (OLED)) displays and liquid crystal displays, members for vehicles including automobiles such as consoles, A-pillars, roofs, and bumpers, and building materials such as walls of houses are exemplified.

Hereinafter, details of the piezoelectric film 12 will be described.

As shown in Figs. 2 and 5, the piezoelectric film 12 has a piezoelectric layer 20 which is a sheet-like member having piezoelectric characteristics, a first electrode layer 24 laminated on one surface of the piezoelectric layer 20, a first protective layer 28 laminated on the first electrode layer 24, a second electrode layer 26 laminated on the other surface of the piezoelectric layer 20, and a second protective layer 30 laminated on the second electrode layer 26. That is, the piezoelectric film 12 has a configuration in which the first protective layer 28, the first electrode layer 24, the piezoelectric layer 20, the second electrode layer 26, and the second protective layer 30 are laminated in this order. As will be described later, as a preferred embodiment, the piezoelectric film 12 (piezoelectric layer 20) is polarized in the thickness direction. The electrode layer and the protective layer on the upstream side in the polarization direction of the piezoelectric film 12 are the first electrode layer 24 and the first protective layer 28, and the electrode layer and the protective layer on the downstream side are the second electrode layer 26 and the second protective layer 30.

In the piezoelectric film 12, as a preferable aspect, as conceptually shown in Fig. 2, the piezoelectric layer 20 consists of a polymer-based piezoelectric composite material in which piezoelectric particles 36 are dispersed in a viscoelastic matrix 34 consisting of a polymer material having viscoelasticity at room temperature. Furthermore, in this specification, the "room temperature" indicates a temperature range of approximately 0°C to 50°C.

Here, it is preferable that the polymer-based piezoelectric composite material (the piezoelectric layer 20) has the following requisites.

### (i) Flexibility

For example, in a case of being gripped in a state of being loosely bent like a newspaper or a magazine as a portable device, the polymer-based piezoelectric composite material is continuously subjected to large bending deformation from the outside at a comparatively slow vibration of equal to or less than a few Hz. At this time, in a case where the polymer-based piezoelectric composite material is hard, large bending stress is generated to that extent, and a crack is generated at the interface between the polymer matrix and the piezoelectric particles, possibly leading to breakage. Accordingly, the polymer-based piezoelectric composite material is required to have suitable flexibility. In addition, in a case where strain energy is diffused into the outside as heat, the stress is able to be relieved. Accordingly, the loss tangent of the polymer-based piezoelectric composite material is required to be suitably large.

As described above, a flexible polymer-based piezoelectric composite material used as an exciter is required to be rigid with respect to vibration of 20 Hz to 20 kHz, and be flexible with respect to vibration of equal to or less than a few Hz. In addition, the loss tangent of the polymer-based piezoelectric composite material is required to be suitably large with respect to the vibration of all frequencies of equal to or less than 20 kHz.

Furthermore, it is preferable that the spring constant can be easily adjusted by lamination in accordance with the rigidity (hardness, stiffness, spring constant) of the mating material (vibration plate) to be cemented. At that time, the thinner the adhesive layer 14 is, the higher energy efficiency can be.

In general, a polymer solid has a viscoelasticity relieving mechanism, and a molecular movement having a large scale is observed as a decrease (relief) in a storage elastic modulus (Young's modulus) or the local maximum (absorption) in a loss elastic modulus along with an increase in a temperature or a decrease in a frequency. Among them, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer-based piezoelectric composite material (the piezoelectric layer 20), the polymer material of which the glass transition point is room temperature, in other words, the polymer material having viscoelasticity at room temperature is used in the matrix, and thus the polymer-based piezoelectric composite material which is rigid with respect to vibration of 20 Hz to 20 kHz and is flexible with respect to vibration of equal to or less than a few Hz is realized. In particular, from a viewpoint of suitably exhibiting such behavior, it is preferable that a polymer material of which the glass transition point at a frequency of 1 Hz is room temperature, that is, equal to or greater than 0°C and equal to or less than 50°C is used in the matrix of the polymer-based piezoelectric composite material.

As the polymer material having viscoelasticity at room temperature, various known materials are able to be used. Preferably, a polymer material of which the local maximum value of a loss tangent Tanδ at a frequency of 1 Hz at room temperature, that is, equal to or greater than 0°C and equal to or less than 50°C in a dynamic viscoelasticity test is greater than or equal to 0.5 is used.

Accordingly, in a case where the polymer-based piezoelectric composite material is slowly bent due to an external force, stress concentration on the interface between the polymer matrix and the piezoelectric particles at the maximum bending moment portion is relieved, and thus high flexibility is able to be expected.

In addition, it is preferable that, in the polymer material having viscoelasticity at room temperature, a storage elastic modulus (E') at a frequency of 1 Hz in accordance with dynamic viscoelasticity measurement is greater than or equal to 100 MPa at 0°C and is equal to or less than 10 MPa at 50°C.

Accordingly, it is possible to reduce a bending moment which is generated in a case where the polymer-based piezoelectric composite material is slowly bent due to the external force, and it is possible to make the polymer-based piezoelectric composite material rigid with respect to acoustic vibration of 20 Hz to 20 kHz.

In addition, it is more suitable that the relative permittivity of the polymer material having viscoelasticity at room temperature is greater than or equal to 10 at 25°C. Accordingly, in a case where a voltage is applied to the polymer-based piezoelectric composite material, a higher electric field is applied to the piezoelectric particles in the polymer matrix, and thus a large deformation amount is able to be expected.

However, in consideration of ensuring favorable moisture resistance or the like, it is suitable that the relative permittivity of the polymer material is equal to or less than 10 at 25°C.

As the polymer material having viscoelasticity at room temperature and satisfying such conditions, cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, polybutyl methacrylate, and the like are exemplified. In addition, as these polymer materials, a commercially available product such as Hybrar 5127 (manufactured by Kuraray Co., Ltd.) is also able to be suitably used. Among them, as the polymer material, a material having a cyanoethyl group is preferably used, and cyanoethylated PVA is particularly preferably used.

Furthermore, only one of these polymer materials may be used, or a plurality of types thereof may be used in combination (mixture).

The viscoelastic matrix 34 using such a polymer material having viscoelasticity at room temperature, as necessary, may use a plurality of polymer materials in combination.

That is, in order to control dielectric properties or mechanical properties, other dielectric polymer materials may be added to the viscoelastic matrix 34 in addition to the viscoelastic material such as cyanoethylated PVA, as necessary.

As the dielectric polymer material which is able to be added to the viscoelastic matrix, for example, a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, and a polyvinylidene fluoride-tetrafluoroethylene copolymer, a polymer having a cyano group or a cyanoethyl group such as a vinylidene cyanide-vinyl acetate copolymer, cyanoethyl cellulose, cyanoethyl hydroxy saccharose, cyanoethyl hydroxy cellulose, cyanoethyl hydroxy pullulan, cyanoethyl methacrylate, cyanoethyl acrylate, cyanoethyl hydroxy ethyl cellulose, cyanoethyl amylose, cyanoethyl hydroxy propyl cellulose, cyanoethyl dihydroxy propyl cellulose, cyanoethyl hydroxy propyl amylose, cyanoethyl polyacryl amide, cyanoethyl polyacrylate, cyanoethyl pullulan, cyanoethyl polyhydroxy methylene, cyanoethyl glycidol pullulan, cyanoethyl saccharose, and cyanoethyl sorbitol, and a synthetic rubber such as nitrile rubber or chloroprene rubber are exemplified.

Among them, a polymer material having a cyanoethyl group is suitably used.

Furthermore, the dielectric polymer added to the viscoelastic matrix 34 of the piezoelectric layer 20 in addition to the material having viscoelasticity at room temperature such as cyanoethylated PVA is not limited to one dielectric polymer, and a plurality of dielectric polymers may be added.

In addition, for the purpose of controlling the glass transition point Tg, a thermoplastic resin such as a vinyl chloride resin, polyethylene, polystyrene, a methacrylic resin, polybutene, and isobutylene, and a thermosetting resin such as a phenol resin, a urea resin, a melamine resin, an alkyd resin, or mica may be added to the viscoelastic matrix 34 in addition to the dielectric polymer.

Furthermore, for the purpose of improving pressure sensitive adhesiveness, a viscosity imparting agent such as rosin ester, rosin, terpene, terpene phenol, and a petroleum resin may be added.

The amount of materials added to the viscoelastic matrix 34 of the piezoelectric layer 20 in a case where materials other than the polymer material having viscoelasticity such as cyanoethylated PVA is not particularly limited, and it is preferable that a ratio of the added materials to the viscoelastic matrix 34 is equal to or less than 30 mass%.

Accordingly, it is possible to exhibit properties of the polymer material to be added without impairing the viscoelasticity relieving mechanism of the viscoelastic matrix 34, and thus a preferable result is able to be obtained from a viewpoint of increasing a dielectric constant, of improving heat resistance, and of improving adhesiveness between the piezoelectric particles 36 and the electrode layer.

The piezoelectric particles 36 consist of ceramics particles having a perovskite type or wurtzite type crystal structure.

As the ceramics particles forming the piezoelectric particles 36, for example, lead zirconate titanate (PZT), lead lanthanum zirconate titanate (PLZT), barium titanate (BaTiO₃), zinc oxide (ZnO), and a solid solution (BFBT) of barium titanate and bismuth ferrite (BiFe₃) are exemplified.

The particle diameter of the piezoelectric particles 36 is not limited, and may be appropriately selected depending on the size of the piezoelectric film 12 and the usage of the laminated piezoelectric element 10. The particle diameter of the piezoelectric particles 36 is preferably equal to or greater than 1 µm and equal to or less than 10 µm.

By setting the particle diameter of the piezoelectric particles 36 to be in the range described above, a preferable result is able to be obtained from a viewpoint of allowing the piezoelectric film 12 to achieve both high piezoelectric characteristics and flexibility.

In addition, in Fig. 2, the piezoelectric particles 36 in the piezoelectric layer 20 are uniformly dispersed in the viscoelastic matrix 34 with regularity. However, the present invention is not limited thereto.

That is, in the viscoelastic matrix 34, it is preferable that the piezoelectric particles 36 in the piezoelectric layer 20 are uniformly dispersed, and may also be irregularly dispersed.

In the piezoelectric film 12, a quantitative ratio of the viscoelastic matrix 34 and the piezoelectric particles 36 in the piezoelectric layer 20 is not limited, and may be appropriately set in accordance with the size in the plane direction or the thickness of the piezoelectric film 12, the usage of the laminated piezoelectric element 10, properties required for the piezoelectric film 12, and the like.

The volume fraction of the piezoelectric particles 36 in the piezoelectric layer 20 is set to preferably equal to or greater than 30% and equal to or less than 80%, more preferably equal to or greater than 50%, and therefore even more preferably equal to or greater than 50% and equal to or less than 80%.

By setting the quantitative ratio of the viscoelastic matrix 34 and the piezoelectric particles 36 to be in the range described above, it is possible to obtain a preferable result from a viewpoint of making high piezoelectric characteristics and flexibility compatible.

In the above-mentioned piezoelectric film 12, as a preferable aspect, the piezoelectric layer 20 is a polymer-based piezoelectric composite layer formed by dispersing piezoelectric particles in a viscoelastic matrix containing a polymer material having viscoelasticity at room temperature. However, the present invention is not limited thereto, and various known piezoelectric layers used in known piezoelectric elements are able to be used as the piezoelectric layer of the piezoelectric film.

For example, a piezoelectric layer consisting of the above-mentioned dielectric polymer material such as polyvinylidene fluoride (PVDF) and a vinylidene fluoride-tetrafluoroethylene copolymer, and a piezoelectric layer consisting of the above-mentioned piezoelectric material such as PZT, PLZT, barium titanate, zinc oxide, or BFBT are exemplified.

In the piezoelectric film 12, the thickness of the piezoelectric layer 20 is not particularly limited, and may be appropriately set in accordance with the usage of the laminated piezoelectric element 10, the number of laminated piezoelectric films in the laminated piezoelectric element 10, properties required for the piezoelectric film 12, and the like.

The thicker the piezoelectric layer 20, the more advantageous it is in terms of rigidity such as the stiffness of a so-called sheet-like member, but the voltage (potential difference) required to stretch and contract the piezoelectric film 12 by the same amount increases.

The thickness of the piezoelectric layer 20 is preferably equal to or greater than 10 µm and equal to or less than 300 µm, more preferably equal to or greater than 20 µm and equal to or less than 200 µm, and even more preferably equal to or greater than 30 µm and equal to or less than 150 µm.

By setting the thickness of the piezoelectric layer 20 to be in the range described above, it is possible to obtain a preferable result from a viewpoint of compatibility between ensuring the rigidity and appropriate flexibility, or the like.

As shown in Fig. 2, the piezoelectric film 12 in the shown example has a configuration in which the first electrode layer 24 is provided on one surface of the piezoelectric layer 20, the first protective layer 28 is provided thereon, the second electrode layer 26 is provided on the other surface of the piezoelectric layer 20, and the second protective layer 30 is provided thereon. Here, the second electrode layer 26 and the first electrode layer 24 form an electrode pair.

In addition to these layers, the piezoelectric film 12 may have, for example, an end surface covering layer or the like that covers a region such as a side surface where the piezoelectric layer 20 is exposed to prevent a short circuit or the like. The end surface covering layer will be described in detail later.

That is, the piezoelectric film 12 has a configuration in which both surfaces of the piezoelectric layer 20 are interposed between the electrode pair, that is, the first electrode layer 24 and the second electrode layer 26 and the laminate is further interposed between the first protective layer 28 and the second protective layer 30.

As described above, in the piezoelectric film 12, the region interposed between the first electrode layer 24 and the second electrode layer 26 is stretched and contracted in accordance with an applied voltage.

As described above, the first electrode layer 24 and the first protective layer 28, and the second electrode layer 26 and the second protective layer 30 are named in accordance with the polarization direction of the piezoelectric layer 20. Accordingly, the first electrode layer 24 and the second electrode layer 26, and the first protective layer 28 and the second protective layer 30 have basically the same configuration.

In the piezoelectric film 12, the first protective layer 28 and the second protective layer 30 have a function of covering the first electrode layer 24 and the second electrode layer 26 and applying appropriate rigidity and mechanical strength to the piezoelectric layer 20. That is, there may be a case where, in the piezoelectric film 12, the piezoelectric layer 20 consisting of the viscoelastic matrix 34 and the piezoelectric particles 36 exhibits extremely superior flexibility under bending deformation at slow vibration but has insufficient rigidity or mechanical strength depending on the usage. As a compensation for this, the piezoelectric film 12 is provided with the first protective layer 28 and the second protective layer 30.

The first protective layer 28 and the second protective layer 30 are not limited, and may use various sheet-like members. For example, various resin films are suitably exemplified.

Among them, by the reason of excellent mechanical properties and heat resistance, a resin film consisting of polyethylene terephthalate (PET), polypropylene (PP), polystyrene (PS), polycarbonate (PC), polyphenylene sulfite (PPS), polymethyl methacrylate (PMMA), polyetherimide (PEI), polyimide (PI), polyethylene naphthalate (PEN), triacetylcellulose (TAC), or a cyclic olefin-based resin is suitably used.

There is no limitation on the thicknesses of the first protective layer 28 and the second protective layer 30. In addition, the thicknesses of the first protective layer 28 and the second protective layer 30 may basically be identical to each other or different from each other from each other.

Here, in a case where the rigidity of the first protective layer 28 and the second protective layer 30 is excessively high, not only is the stretching and contracting of the piezoelectric layer 20 constrained, but also the flexibility is impaired. Therefore, there is an advantage in a case where the thicknesses of first protective layer 28 and the second protective layer 30 are smaller unless mechanical strength or favorable handleability as a sheet-like member is required.

In the piezoelectric film 12, in a case where the thickness of the first protective layer 28 and the second protective layer 30 is equal to or less than twice the thickness of the piezoelectric layer 20, it is possible to obtain a preferable result from a viewpoint of compatibility between ensuring the rigidity and appropriate flexibility, or the like.

For example, in a case where the thickness of the piezoelectric layer 20 is 50 µm and the first protective layer 28 and the second protective layer 30 consist of PET, the thickness of the second protective layer 30 and the first protective layer 28 is preferably equal to or less than 100 µm, more preferably equal to or less than 50 µm, and even more preferably equal to or less than 25 µm.

In the piezoelectric film 12, the first electrode layer 24 is formed between the piezoelectric layer 20 and the first protective layer 28, and the second electrode layer 26 is formed between the piezoelectric layer 20 and the second protective layer 30. The first electrode layer 24 and the second electrode layer 26 are provided to apply a voltage to the piezoelectric layer 20 (the piezoelectric film 12).

In the present invention, a forming material of the first electrode layer 24 and the second electrode layer 26 is not limited, and as the forming material, various conductive bodies are able to be used. Specifically, metals such as carbon, palladium, iron, tin, aluminum, nickel, platinum, gold, silver, copper, titanium, chromium, and molybdenum, alloys thereof, laminates and composites of these metals and alloys, indium-tin oxide, and the like are exemplified. Among them, copper, aluminum, gold, silver, platinum, and indium-tin oxide are suitably exemplified as the first electrode layer 24 and the second electrode layer 26.

In addition, a forming method of the first electrode layer 24 and the second electrode layer 26 is not limited, and various known methods such as a vapor-phase deposition method (a vacuum film forming method) such as vacuum vapor deposition or sputtering, film formation using plating, and a method of cementing a foil formed of the materials described above are able to be used.

Among them, in particular, by the reason that the flexibility of the piezoelectric film 12 is able to be ensured, a thin film made of copper, aluminum, or the like formed by using the vacuum vapor deposition is suitably used as the first electrode layer 24 and the second electrode layer 26. Among them, in particular, the copper thin film formed by using the vacuum vapor deposition is suitably used.

There is no limitation on the thicknesses of the first electrode layer 24 and the second electrode layer 26. Further, the thicknesses of the first electrode layer 24 and the second electrode layer 26 may basically be identical to each other or different from each other.

Here, similarly to the first protective layer 28 and second protective layer 30 mentioned above, in a case where the rigidity of the first electrode layer 24 and the second electrode layer 26 is excessively high, not only is the stretching and contracting of the piezoelectric layer 20 constrained, but also the flexibility is impaired. Therefore, there is an advantage in a case where the thicknesses of first electrode layer 24 and the second electrode layer 26 are smaller as long as electrical resistance is not excessively high.

In the piezoelectric film 12, in a case where the product of the thicknesses of the first electrode layer 24 and the second electrode layer 26 and the Young's modulus is less than the product of the thicknesses of the first protective layer 28 and the second protective layer 30 and the Young's modulus, the flexibility is not considerably impaired, which is suitable.

For example, in a case of a combination consisting of the first protective layer 28 and the second protective layer 30 formed of PET (Young's modulus: approximately 6.2 GPa) and the first electrode layer 24 and the second electrode layer 26 formed of copper (Young's modulus: approximately 130 GPa), in a case where the thickness of the first protective layer 28 and the second protective layer 30 is 25 µm, the thickness of the second electrode layer 26 and the first electrode layer 24 is preferably equal to or less than 1.2 µm, more preferably equal to or less than 0.3 µm, and particularly preferably equal to or less than 0.1 µm.

As described above, the piezoelectric film 12 has a configuration in which the piezoelectric layer 20 in which the piezoelectric particles 36 are dispersed in the viscoelastic matrix 34 containing the polymer material having viscoelasticity at room temperature is interposed between the first electrode layer 24 and the second electrode layer 26 and the laminate is interposed between the first protective layer 28 and the second protective layer 30.

In the piezoelectric film 12, it is preferable that the local maximum value of the loss tangent (Tanδ) at a frequency of 1 Hz in accordance with the dynamic viscoelasticity measurement exists at room temperature, and it is more preferable that a local maximum value of greater than or equal to 0.1 exists at room temperature.

Accordingly, even in a case where the piezoelectric film 12 is subjected to large bending deformation from the outside at a comparatively slow vibration of equal to or less than a few Hz, it is possible to effectively diffuse the strain energy to the outside as heat, and thus it is possible to prevent a crack from being generated on the interface between the polymer matrix and the piezoelectric particles.

In the piezoelectric film 12, it is preferable that the storage elastic modulus (E') at a frequency of 1 Hz in accordance with the dynamic viscoelasticity measurement is 10 to 30 GPa at 0°C, and 1 to 10 GPa at 50°C.

Accordingly, the piezoelectric film 12 is able to have large frequency dispersion in the storage elastic modulus (E') at room temperature. That is, the piezoelectric film 12 is able to be rigid with respect to vibration equal to or greater than 20 Hz and equal to or less than 20 kHz, and is able to be flexible with respect to vibration of equal to or less than a few Hz.

In addition, in the piezoelectric film 12, it is preferable that the product of the thickness and the storage elastic modulus (E') at a frequency of 1 Hz in accordance with the dynamic viscoelasticity measurement is 1.0 × 10⁶ to 2.0 × 10⁶ N/m at 0°C, and 1.0 × 10⁵ to 1.0 × 10⁶ N/m at 50°C.

Accordingly, the piezoelectric film 12 is able to have appropriate rigidity and mechanical strength within a range not impairing the flexibility and the acoustic properties.

Furthermore, in the piezoelectric film 12, it is preferable that the loss tangent (Tanδ) at a frequency of 1 kHz at 25°C is greater than or equal to 0.05 in a master curve obtained by the dynamic viscoelasticity measurement.

Accordingly, the frequency properties of a speaker using the piezoelectric film 12 are smoothened, and thus it is also possible to decrease the changed amount of acoustic quality in a case where the lowest resonance frequency f₀ is changed in accordance with a change in the curvature of the speaker.

As described above, the end surface covering layer 32 is formed to cover the end surface of the laminate in which the first protective layer 28, the first electrode layer 24, the piezoelectric layer 20, the second electrode layer 26, and the second protective layer 30 are laminated in this order.

The forming material of the end surface covering layer 32 is not limited, and various known materials can be used as long as the materials have insulating properties.

For example, polyimide, heat-resistant polyethylene terephthalate and the like are shown as examples.

There is no limitation on the thickness of the end surface covering layer 32, and a thickness that can prevent a short circuit may be suitably set. The thickness of the end surface covering layer 32 (thickness in the direction perpendicular to the principal surface of the protective layer and thickness in the direction perpendicular to the end surface) is preferably equal to or greater than 3 µm and equal to or less than 100 µm.

In the present invention, as necessary, the water vapor permeability of the end surface covering layer 32 may be set to 100 g/(m²·day) or less, and the end surface covering layer 32 may have a gas barrier property. By having such an end surface covering layer 32, deterioration of the piezoelectric layer 20 can be prevented even in a case where the components constituting the piezoelectric layer 20 are deteriorated by moisture.

In the present invention, various known adhesive layers 14 can be used as long as the adjacent piezoelectric films 12 can be cemented.

Accordingly, the adhesive layer 14 may be a layer consisting of an adhesive, which has fluidity during cementing and thereafter is a solid, a layer consisting of a pressure sensitive adhesive which is a gel-like (rubber-like) flexible solid during cementing and does not change in the gel-like state thereafter, or a layer consisting of a material having characteristics of both an adhesive and a pressure sensitive adhesive.

Here, for example, in the laminated piezoelectric element 10 of the present invention, a vibration plate is cemented, and the vibration plate is vibrated as described later to generate a sound by stretching and contracting the plurality of laminated piezoelectric films. Accordingly, in the laminated piezoelectric element 10 of the present invention, it is preferable that the stretching and contracting of each piezoelectric film is directly transmitted. In a case where a substance having a viscosity that attenuates vibration is present between the piezoelectric films, the efficiency of transmitting the stretching and contracting energy of the piezoelectric film is lowered, and the driving efficiency of the laminated piezoelectric element 10 is also decreased.

In consideration of this point, the adhesive layer 14 is preferably an adhesive layer consisting of an adhesive with which a solid and hard adhesive layer 14 is obtained, rather than a pressure sensitive adhesive layer consisting of a pressure sensitive adhesive. As a more preferable adhesive layer 14, specifically, a cementing layer consisting of a thermoplastic type adhesive such as a polyester-based adhesive or a styrene-butadiene rubber (SBR)-based adhesive is suitably exemplified.

Adhesion, unlike pressure sensitive adhesion, is useful in a case where a high adhesion temperature is required. Furthermore, the thermoplastic type adhesive has "relatively low temperature, short time, and strong adhesion" and is suitable.

In the laminated piezoelectric element 10 of the present invention, the thickness of the adhesive layer 14 is not limited, and a thickness capable of exhibiting sufficient cementing force (adhesive force or pressure sensitive adhesive force) may be appropriately set depending on the forming material of the adhesive layer 14.

Here, in the laminated piezoelectric element 10 of the present invention, the thinner the adhesive layer 14, the higher the transmission effect of the stretching and contracting energy (vibration energy) of the piezoelectric layer 20, and the higher the energy efficiency. In addition, in a case where the adhesive layer 14 is thick and has high rigidity, there is a possibility that the stretching and contracting of the piezoelectric film may be constrained. Furthermore, in the laminated piezoelectric element 10 of the present invention, since there is no concern that the adjacent piezoelectric films 12 may be short-circuited, the adhesive layer 14 can be made thin.

In consideration of this point, the adhesive layer 14 is preferably thinner than the piezoelectric layer 20. That is, in the laminated piezoelectric element 10 of the present invention, the adhesive layer 14 is preferably hard and thin.

Specifically, the thickness of the adhesive layer 14 is preferably equal to or greater than 0.1 µm and equal to or less than 50 µm, more preferably equal to or greater than 0.1 µm and equal to or less than 30 µm, and even more preferably equal to or greater than 0.1 µm and equal to or less than 10 µm in terms of thickness after cementing.

In the laminated piezoelectric element 10 of the present invention, in a case where the spring constant of the adhesive layer 14 is high, there is a possibility that the stretching and contracting of the piezoelectric film 12 may be constrained. Accordingly, the spring constant of the adhesive layer 14 is preferably equal to or less than the spring constant of the piezoelectric film 12. The spring constant is "thickness × Young's modulus".

Specifically, the product of the thickness of the adhesive layer 14 and the storage elastic modulus (E') at a frequency of 1 Hz in accordance with the dynamic viscoelasticity measurement is preferably 2.0 × 10⁶ N/m or less at 0°C and 1.0 × 10⁶ N/m or less at 50°C.

It is preferable that the internal loss of the cementing layer at a frequency of 1 Hz in accordance with the dynamic viscoelasticity measurement is 1.0 or less at 25°C in the case of the adhesive layer 14 consisting of a pressure sensitive adhesive, and is 0.1 or less at 25°C in the case of the adhesive layer 14 consisting of an adhesive.

Next, an example of a manufacturing method of the piezoelectric film 12 will be described with reference to Figs. 12 to 14.

First, as shown in Fig. 12, a sheet-like member 11a is provided in which the first electrode layer 24 is formed on the first protective layer 28. The sheet-like member 11a may be produced by forming a copper thin film or the like as the first electrode layer 24 on the surface of the first protective layer 28 using vacuum vapor deposition, sputtering, plating, or the like.

In a case where the first protective layer 28 is extremely thin, and thus the handleability is degraded, the first protective layer 28 with a separator (temporary support) may be used as necessary. As the separator, a PET film having a thickness of 25 to 100 µm, and the like are able to be used. The separator may be removed after thermal compression bonding of the second electrode layer 26 and the second protective layer 30 and before laminating any member on the first protective layer 28.

On the other hand, a coating material is provided by dissolving a polymer material having viscoelasticity at room temperature, such as cyanoethylated PVA, in an organic solvent, further adding the piezoelectric particles 36 such as PZT particles thereto, and stirring and dispersing the resultant. In the following description, the polymer material having viscoelasticity at room temperature, such as cyanoethylated PVA, is also referred to as a "viscoelastic material".

The organic solvent is not limited, and various organic solvents such as dimethylformamide (DMF), methyl ethyl ketone, and cyclohexanone are able to be used.

In a case where the sheet-like member 11a is provided and the coating material is provided, the coating material is cast (applied) onto the sheet-like member 11a, and the organic solvent is evaporated and dried. Accordingly, as shown in Fig. 13, a laminate 11b in which the first electrode layer 24 is provided on the first protective layer 28 and the piezoelectric layer 20 is formed on the first electrode layer 24 is produced.

A casting method of the coating material is not particularly limited, and all known coating methods (coating devices) such as a slide coater or a doctor knife are able to be used.

Alternatively, in a case where the viscoelastic material is a material that is able to be heated and melted like cyanoethylated PVA, a melted material may be produced by heating and melting the viscoelastic material and adding and dispersing the piezoelectric particles 36 therein, extruded into a sheet shape on the sheet-like member 11a shown in Fig. 12 by extrusion molding or the like, and cooled, thereby producing the laminate 11b in which the first electrode layer 24 is provided on the first protective layer 28 and the piezoelectric layer 20 is formed on the first electrode layer 24 as shown in Fig. 13.

As described above, in the piezoelectric film 12, in addition to the viscoelastic material such as cyanoethylated PVA, a polymer piezoelectric material such as PVDF may be added to the viscoelastic matrix 34.

In a case where the polymer piezoelectric material is added to the viscoelastic matrix 34, the polymer piezoelectric material added to the coating material may be dissolved. Alternatively, the polymer piezoelectric material to be added may be added to the heated and melted viscoelastic material and may be heated and melted.

After the piezoelectric layer 12 is formed, a calendar processing may be performed, as necessary. The calendar processing may be performed once or a plurality of times.

As well known, the calendar processing is processing in which a surface to be treated is pressed while being heated by a heating press, a heating roller, or the like to perform flattening or the like.

After the laminate 11b in which the first electrode layer 24 is provided on the first protective layer 28 and the piezoelectric layer 20 is formed on the first electrode layer 24 is produced, the piezoelectric layer 20 is subjected to polarization processing (poling).

A polarization processing method of the piezoelectric layer 20 is not limited, and a known method is able to be used.

For example, electric field poling in which a direct current electric field is directly applied to an object subjected to the polarization processing is shown as an example. In a case of performing electric field poling, the first electrode layer 14 may be formed before the polarization processing, and the electric field poling processing may be performed using the first electrode layer 14 and the second electrode layer 16.

Further, in a case of manufacturing the piezoelectric film 10 of the present invention, the polarization processing performs polarization in the thickness direction, not in the plane direction of the piezoelectric layer 12.

Further, a sheet-like member 11c in which the second electrode layer 26 is formed on the second protective layer 30 is provided. The sheet-like member 11c may be produced by forming a copper thin film or the like as the second electrode layer 26 on the surface of the second protective layer 30 using vacuum vapor deposition, sputtering, plating, or the like.

Next, as shown in Fig. 14, the sheet-like member 11c is laminated on the laminate 11b in which the piezoelectric layer 20 is subjected to the polarization processing while the second electrode layer 26 faces the piezoelectric layer 20.

Furthermore, a laminate of the laminate 11b and the sheet-like member 11c is interposed between the second protective layer 30 and the first protective layer 28, and is subjected to the thermal compression bonding using a heating press device, a heating roller pair, or the like. Thereby, the piezoelectric film 12 is manufactured.

As the piezoelectric film, it is preferable to prepare a long-size (large-area) piezoelectric film and cut the long piezoelectric film into individual piezoelectric films. Accordingly, in such a case, layer configurations (thickness, material, and the like of each layer) of the plurality of piezoelectric films constituting the laminated piezoelectric element 10 are all the same.

However, the present invention is not limited thereto. That is, the laminated piezoelectric element of the present invention can be used in various configurations, such as a configuration in which piezoelectric films having different layer configurations are laminated, and a configuration in which piezoelectric films having different thicknesses of the piezoelectric layer 20 are laminated.

Further, a method of forming the end surface covering layer 32 on the end surface of the piezoelectric film 12 will be described.

The method of forming the end surface covering layer 32 on the end surface of the laminate is not limited, and a known forming method (film forming method) according to the forming material of the end surface covering layer 32 can be used.

For example, the following are exemplified: a method of cementing an insulating pressure sensitive adhesive tape, a method of applying a liquid in which a material to form the end surface covering layer 32 is dissolved and dried, a method of applying and curing a liquid in which the material to form the end surface covering layer 32 is heated and melted, and a method of dissolving the resin to form the end surface covering layer 32 in a solvent, spraying the resin, and drying the resin. Examples of the insulating pressure sensitive adhesive tape include a pressure sensitive adhesive tape consisting of polyimide, polyethylene terephthalate, or the like.

The method of applying the liquid at this time is not limited, and various known methods can be used. For example, spray coating, immersion coating and the like are shown as an example.

Further, in accordance with the forming method, the end surface covering layer 32 is likely to be formed up to the principal surface of the first protective layer 28 and/or the second protective layer 30. For example, in a case where the piezoelectric film 12 is immersed in a solution in which the resin to form the end surface covering layer 32 is dissolved, a part of the principal surfaces of the first protective layer 28 and the second protective layer 30 is also immersed in the solution. Therefore, the end surface covering layer 32 is formed in a range up to the principal surfaces of the first protective layer 28 and the second protective layer 30.

As described above, as shown in Fig. 11, after the plurality of layers of the piezoelectric films 12 are laminated, the end surface covering layer 32 may be formed on the end surface of the laminated film.

Here, as described above, the piezoelectric layers 20 of the piezoelectric films 12 are preferably polarized.

In a case where the piezoelectric layer 20 is polarized, the plurality of piezoelectric films 12 are laminated such that the polarization directions thereof are the same in a case where the phases of the voltages applied to the electrode layers are matched in accordance with the polarization direction. Alternatively, some may be laminated such that the polarization directions are opposite to each other. Consequently, a voltage having the same phase may be applied to the first electrode layer 24 of each piezoelectric film 12, and a voltage having the same phase may be applied to the second electrode layer 26.

Preferably, the plurality of piezoelectric films 12 are laminated such that the polarization directions are alternated. That is, it is preferable that the polarization directions of the adjacent piezoelectric films 12 are opposite to each other.

In the laminated piezoelectric element 10 in which the piezoelectric films 12 are laminated such that the polarization directions of the piezoelectric layers 20 are alternated, the adjacent piezoelectric films 12 face each other with the second electrode layers 26 or the first electrode layers 24 with each other. Therefore, this configuration is preferable in that there is no risk of short-circuiting even in a case where the electrode layers of the adjacent piezoelectric films come into contact with each other.

In the present invention, the polarization direction of each piezoelectric film (piezoelectric layer) may be detected by a d33 meter or the like.

Alternatively, the polarization direction of the piezoelectric layer 20 may be known from the processing conditions of the corona poling processing described above.

Each piezoelectric film 12 may be provided with an electrode lead-out portion for connecting the first electrode layer 24 and the second electrode layer 26 to the power source. The electrode lead-out portion is not limited, and a known electrode lead-out portion configuration can be suitably used.

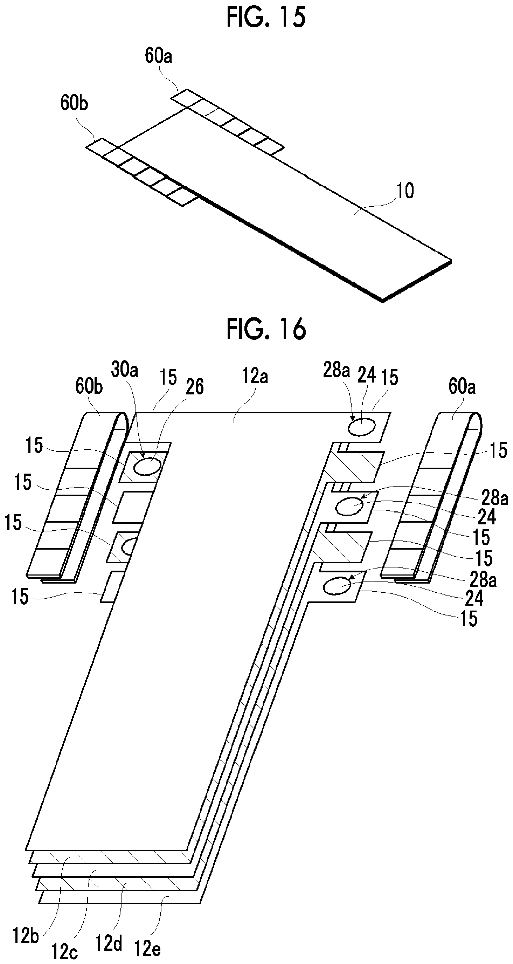

Examples of the electrode lead-out portions provided on the piezoelectric films 12 will be described with reference to Figs. 15 to 17.

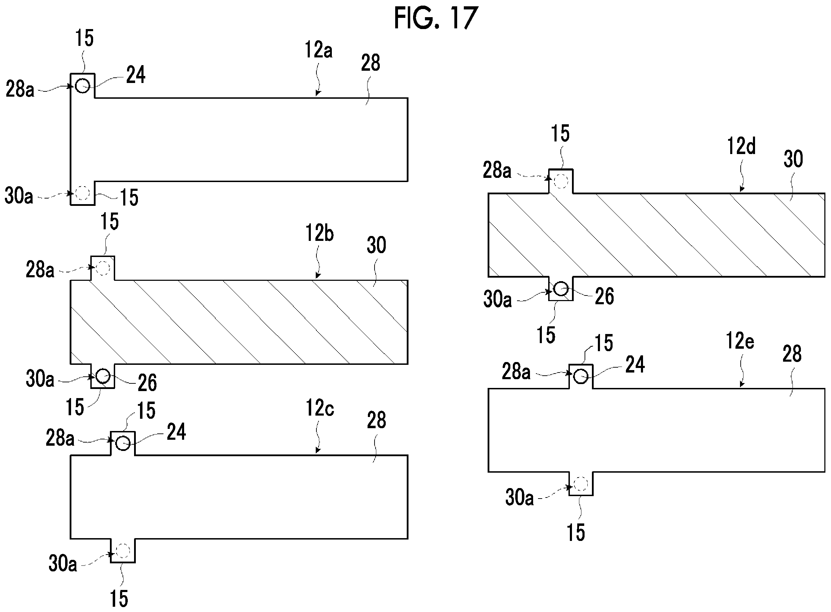

Fig. 15 is a diagram conceptually showing an example of a laminated piezoelectric element of the present invention. Fig. 16 is an exploded view of Fig. 15. Fig. 17 is a diagram showing the plurality of piezoelectric films included in the laminated piezoelectric element of Fig. 15.

The examples shown in Figs. 15 and 16 have a configuration in which five piezoelectric films are laminated. The piezoelectric films are laminated such that the polarization directions are alternated. In Figs. 16 and 17, the surface of the piezoelectric film on the second protective layer side is shown with hatching. That is, in Fig. 16, the first layer piezoelectric film 12a in Fig. 16 is laminated with the first protective layer 28 side facing upward, the second layer piezoelectric film 12b is laminated with the second protective layer 30 side facing upward, the third layer piezoelectric film 12c is laminated with the first protective layer 28 side facing upward, the fourth layer piezoelectric film 12d is laminated with the second protective layer 30 side facing upward, and the fifth layer piezoelectric film 12e is laminated with the first protective layer 28 side facing upward.

As shown in Figs. 16 and 17, each piezoelectric film has a rectangular principal portion and two protruding portions 15 protruding outward from the long side of the principal portion in the plane direction. The two protruding portions 15 are provided so as to protrude from the opposite long sides of the principal portion. In the present invention, the size of the principal portion of each piezoelectric film is different, and the positions of the end sides in the plane direction are different, but this point is not repeated in Figs. 15 and 16.

As shown in Fig. 17, the first layer piezoelectric film 12a has the protruding portion 15 formed on one end side on the long side. In the second layer piezoelectric film 12b, the protruding portion 15 is formed at a position shifted from the position of the first layer protruding portion 15 piezoelectric film 12a to the other end side. In the third layer piezoelectric film 12c, the protruding portion 15 is formed at a position shifted from the position of the second layer protruding portion 15 piezoelectric film 12b to the other end side. In the fourth layer piezoelectric film 12d, the protruding portion 15 is formed at a position shifted from the position of the third layer protruding portion 15 piezoelectric film 12c to the other end side. In the fifth layer piezoelectric film 12e, the protruding portion 15 is formed at a position shifted from the position of the fourth layer protruding portion 15 piezoelectric film 12d to the other end side.

In the example shown in Fig. 17, the protruding portion of each piezoelectric film is formed at a position shifted by one protruding portion from the position of the protruding portion of the adjacent piezoelectric film.

Further, a hole portion 28a penetrating the first protective layer 28 is provided in the protruding portion 15 on one long side of each piezoelectric film, and the first electrode layer 24 is exposed in the hole portion 28a. Further, the protruding portion 15 on the other long side of each piezoelectric film is provided with a hole portion 30a penetrating the second protective layer 30, and the second electrode layer 26 is exposed in the hole portion 30a. The protruding portion 15 is not cemented to the adjacent piezoelectric film. Accordingly, wiring line or the like can be connected to the first electrode layer 24 in the hole portion 28a. In the following description, the hole portion 28a (the first electrode layer 24 in the hole portion 28a) is also referred to as a first contact. Similarly, wiring line or the like can be connected to the second electrode layer 26 in the hole portion 30a. In the following description, the hole portion 30a (second electrode layer 26 in the hole portion 30a) is also referred to as a second contact.

That is, the first contact 28a is formed on the protruding portion 15 on one long side of each piezoelectric film, and the second contact 30a is formed on the protruding portion 15 on the other long side.

In a case where such five piezoelectric films are laminated, as shown in Fig. 16, the protruding portions 15 of the piezoelectric films are disposed so as not to overlap with each other in the plane direction.

In addition, the first contact 28a is formed on each of the protruding portions 15 on the long side (the long side on the right side in Fig. 16) of each piezoelectric film. As described above, the first, third, and fifth layer piezoelectric films and the second and fourth layer piezoelectric films are laminated in opposite directions. Therefore, the first contacts 28a are formed on the surfaces opposite to each other.

A conductive film 60a is cemented to the five protruding portions 15 on which the first contacts 28a are formed from the front surface to the rear surface. Thereby, the first contact 28a of each piezoelectric film is easily electrically connected.

In a similar manner, the second contact 30a is formed on each of the protruding portions 15 on the other long side (the long side on the left side in Fig. 16) of each piezoelectric film. As described above, the first, third, and fifth layer piezoelectric films and the second and fourth layer piezoelectric films are laminated in opposite directions. Therefore, the second contacts 30a are formed on the surfaces opposite to each other.

A conductive film 60b is cemented to the five protruding portions 15 on which the second contacts 30a are formed from the front surface to the rear surface. Thereby, the second contact 30a of each piezoelectric film is easily electrically connected.

The shapes of the hole portion 28a formed in the first protective layer 28 of the protruding portion 15 and the hole portion 30a formed in the second protective layer 30 are not particularly limited as long as they can be reliably connected to the electrode layer, and can have various shapes such as a circular shape, an elliptical shape, a rectangular shape, a polygonal shape, and an indefinite shape.

In addition, the sizes of the hole portion 28a and the hole portion 30a are not particularly limited as long as they can be reliably connected to the electrode layer. The diameter equivalent to a circle is preferably equal to or greater than 1 mm and equal to or less than 10 mm and more preferably equal to or greater than 2 mm and equal to or less than 4 mm. Further, it is preferable that a plurality of hole portions are formed in one protruding portion.

Further, the formation positions of the hole portion (first contact) 28a and the hole portion (second contact) 30a are not particularly limited. However, in order to make each piezoelectric film be able to be easily connected to each other, it is preferable that the hole portion (first contact) 28a and the hole portion (second contact) 30a of the film are each formed on the same side of the principal portion.

Examples of the forming method of the hole portion include a method of removing the protective layer by laser processing, solvent etching, mechanical polishing, and the like.

As the conductive films 60a and 60b, sheet-like members formed of a conductive metal material such as a copper foil film may be used. Further, the conductive film and the first contact 28a and the second contact 30a may be connected through a conductive coating material such as silver paste.

Here, in the examples shown in Figs. 15 to 17, each piezoelectric film has two protruding portions, the first contact 28a is formed on one of the two protruding portions 15, and the second contact 30a is formed on the other. However, the configuration is not limited to this. Each piezoelectric film may have one protruding portion, and the first contact 28a and the second contact 30a may be formed on one protruding portion 15. Further, in such a case, the first contact 28a and the second contact 30a may be formed at overlapping positions in the plane direction, but it is preferable that the first contact 28a and the second contact 30a are formed at different positions.

Further, in a case where the piezoelectric films are laminated such that the polarization directions of the piezoelectric layers are the same, the first contact 28a formed on the protruding portion 15 of the piezoelectric film is formed so as to face one same surface side, and the second contact 30a is formed so as to face the other same surface side. Accordingly, a conductive film is cemented to the surface of the protruding portion 15 on a side where the first contact 28a is formed, and the first contact 28a of each piezoelectric film is easily electrically connected. Similarly, another conductive film is cemented to the surface of the protruding portion 15 on which the second contact 30a is formed. Thereby, the second contact 30a of each piezoelectric film is easily electrically connected.

Further, in the examples shown in Figs. 15 and 16, all the protruding portions 15 of the piezoelectric films are disposed at positions that do not overlap with each other in the plane direction. However, the configuration is not limited to this, and there may be overlapping protruding portions.

Alternatively, in the examples shown in Figs. 15 and 16, the protruding portions of the piezoelectric films are disposed at positions where they do not overlap with each other in the plane direction, but the configuration is not limited to this. The protruding portions of the piezoelectric films may protrude from the same position of the cemented portion in the plane direction, and the lengths in the protrusion directions may differ from each other, and contacts may be formed in the exposed regions of the protruding portions.

Further, the protruding portion of each piezoelectric film is not limited to the configuration in which the protruding portion is formed in a part of the width direction of the end side of the principal portion where the protruding portion is formed, and the width of the protruding portion in the direction orthogonal to the protrusion direction may be equal to the width of the end side of the principal portion where the protruding portion is formed.

In the laminated piezoelectric element according to a second embodiment of the present invention,
a plurality of layers of a piezoelectric film having a piezoelectric layer, two electrode layers between which the piezoelectric layer is interposed, and two protective layers respectively covering the electrode layers are laminated by folding back the piezoelectric film one or more times,
in which respective end sides of adjacent layers are located at different positions in a plane direction.

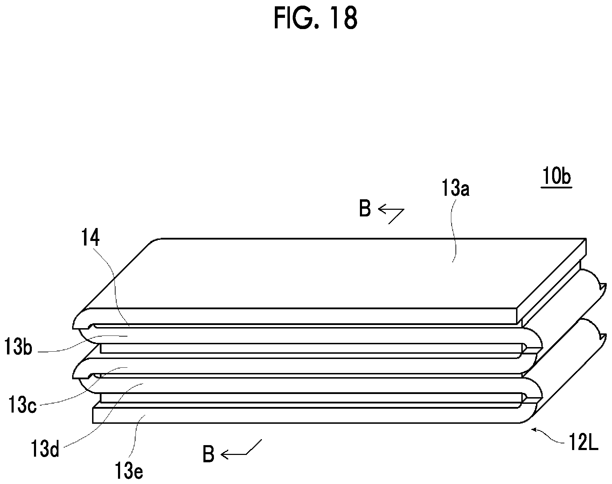

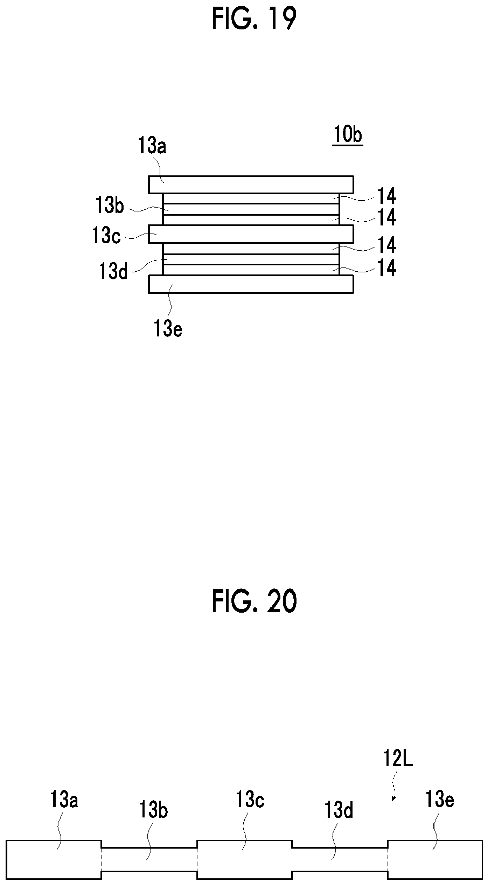

Fig. 18 is a diagram conceptually showing another example of the laminated piezoelectric element of the present invention. Fig. 19 is a cross-sectional view taken along the line BB of Fig. 18. Fig. 20 is a diagram conceptually showing a state in which the laminated piezoelectric element of Fig. 18 is opened.

The laminated piezoelectric element 10b shown in Fig. 18 is formed by laminating the plurality of layers of the piezoelectric film by folding back the piezoelectric film 12L a plurality of times. In the example shown in the drawing, the piezoelectric film 12L is folded back four times to have five layers of the piezoelectric film laminated. Each layer is cemented by the adhesive layer 14.

Here, as shown in Fig. 20, in the piezoelectric film 12L, the width direction orthogonal to the folding-back direction (longitudinal direction of the piezoelectric film 12L) differs depending on the position in the longitudinal direction. Specifically, in the example shown in Fig. 20, regions (13a, 13c, 13e) having a large width and regions (13b, 13d) having a small width are alternately formed in the longitudinal direction.

By folding back the piezoelectric film 12L at a position where the width changes, the end sides of the adjacent piezoelectric films are at different positions in the plane direction.

Specifically, as shown in Fig. 19, the widths of the first layer 13a laminated on the uppermost side in Fig. 19 and the second layer 13b laminated adjacent to the underlayer of the first layer 13a in the left-right direction in Fig. 19 are different, and the positions of the end sides in the plane direction, that is, in the left-right direction in Fig. 19 are different. More specifically, the width of the first layer 13a is greater than that of the second layer 13b, the left end side of the first layer 13a in the drawing is located closer to the left side (outside) than the left end side of the second layer 13b, and the right end side of the first layer 13a in the drawing is located closer to the right side (outside) than the right end side of the second layer 13b.

Further, the second layer 13b and the third layer 13c laminated adjacent to the underlayer of the second layer 13b have different widths in the left-right direction in the drawing, and the positions of the end sides in the plane direction, that is, the left-right direction in Fig. 19 are different. More specifically, the width of the third layer 13c is greater than that of the second layer 13b, the left end side of the third layer 13c in the drawing is located closer to the left side (outside) than the left end side of the second layer 13b, and the right end side of the third layer 13c in the drawing is located closer to the right side (outside) than the right end side of the second layer 13b.

Further, the width of the fourth layer 13d laminated on the underlayer of the third layer 13c is less than that of the third layer 13c, the left end side of the third layer 13c in the drawing is located closer to the left side (outside) than the left end side of the fourth layer 13d, and the right end side of the third layer 13c in the drawing is located closer to the right side (outside) than the right end side of the fourth layer 13d.

Further, the width of the fifth layer 13e laminated on the underlayer of the fourth layer 13d is greater than that of the fourth layer 13d, the left end side of the fifth layer 13e in the drawing is located closer to the left side (outside) than the left end side of the fourth layer 13d, and the right end side of the fifth layer 13e in the drawing is located closer to the right side (outside) than the right end side of the fourth layer 13d.

That is, in the example shown in Fig. 19, layers having a large width and layers having a small width are alternately laminated, and the positions of the left and right end sides are different between the layer having a large width and the layer having a small width.

In such a manner, even in the case of the laminated piezoelectric element 10b in which the piezoelectric film is folded back once or more and a plurality of layers of the piezoelectric film is laminated, the end sides of the adjacent layers are laminated so as to be at different positions in the plane direction. With such a configuration, the distance between the electrode layers of the adjacent piezoelectric film layers can be lengthened, and short-circuiting of the electrode layers can be suppressed.

Here, in the example shown in Fig. 19, the layers having a large width and the layers having a small width are alternately laminated, but the present invention is not limited to this as long as the end sides of the adjacent layers are located at different positions in the plane direction. For example, as in the example shown in Fig. 1, the width of the layer may be larger at a position closer to the underlayer than the upper layer. Alternatively, as in the example shown in Fig. 4, the layer width may be larger at a position closer to the outside (surface side) than the center in the lamination direction.

Further, even in the case of the laminated piezoelectric element 10b in which the piezoelectric film is folded back once or more and a plurality of layers of the piezoelectric film are laminated, the end surface covering layer covering the end surface of the piezoelectric film may be provided.

In such a case, it is preferable that the end surface covering layer covers both end surfaces of the piezoelectric film in the width direction orthogonal to the folding-back direction.

By having the end surface covering layer, it is possible to more suitably suppress short-circuiting between the electrode layers of the adjacent layers.

Further, the end sides of the adjacent layers are located at different positions in the plane direction. Therefore, the difference in thickness between the end part and the central part can be reduced in a case where the end surface covering layer is formed.

From the viewpoint of preventing short-circuiting and reducing the difference in thickness between the end parts and the central part in a case where the end surface covering layer is formed, the distance between the end sides of the adjacent piezoelectric films 12 in the plane direction is preferably equal to or greater than 0.05 mm and equal to or less than 5 mm, more preferably equal to or greater than 0.2 mm and equal to or less than 3 mm, and even more preferably equal to or greater than 0.3 mm and equal to or less than 2 mm.

Further, in the example shown in Fig. 18, the laminated piezoelectric element 10b is formed by folding back the piezoelectric film 12L in the longitudinal direction, but the present invention is not limited to this, and the piezoelectric film 12L may be configured to be folded back in the lateral direction.

While the laminated piezoelectric element of the present invention has been described in detail, the present invention is not limited to the examples described above, and various improvements or modifications may be naturally performed within a range not deviating from the gist of the present invention.

The laminated piezoelectric element can be suitably used as an exciter or the like that abuts on various members to generate a sound.

### Explanation of References

10, 10b: laminated piezoelectric element
11a, 11c: sheet-like member
11b: laminate
12, 12a to 12j, 12L: piezoelectric film
13a to 13e: layer
14: adhesive layer
15: protruding portion
20: piezoelectric layer
24: first electrode layer
26: second electrode layer
28: first protective layer
28a: hole portion (first contact)
30: second protective layer
30a: hole portion (second contact)
34: viscoelastic matrix
36: piezoelectric particles
40: corona electrode
42: direct-current power source
60a and 60b: conductive film

## Claims

1. A laminated piezoelectric element formed by laminating a plurality of layers of piezoelectric films each having a piezoelectric layer, two electrode layers between which the piezoelectric layer is interposed, and two protective layers respectively covering the electrode layers,
wherein at least a part of each end side of the adjacent piezoelectric films is located at a different position in a plane direction.

2. The laminated piezoelectric element according to claim 1,
wherein each of the piezoelectric films has an end surface covering layer that covers an end surface of the piezoelectric film.

3. The laminated piezoelectric element according to claim 1 or 2,
wherein a distance between the end sides of the adjacent piezoelectric films is equal to or greater than 0.05 mm and equal to or less than 2 mm.

4. The laminated piezoelectric element according to any one of claims 1 to 3,
wherein the piezoelectric layer is polarized in a thickness direction, and
the plurality of piezoelectric films are laminated such that polarization directions thereof are alternated.

5. A laminated piezoelectric element in which a plurality of layers of a piezoelectric film having a piezoelectric layer, two electrode layers between which the piezoelectric layer is interposed, and two protective layers respectively covering the electrode layers are laminated by folding back the piezoelectric film one or more times,
wherein respective end sides of adjacent layers are located at different positions in a plane direction.

6. The laminated piezoelectric element according to claim 5,
wherein the piezoelectric film has an end surface covering layer covering both end surfaces in a width direction orthogonal to a folding-back direction of the piezoelectric film.

7. The laminated piezoelectric element according to claim 5 or 6,
wherein a shortest distance between the end sides of the adjacent layers is equal to or greater than 0.05 mm and equal to or less than 5 mm.
